# EUROPÄISCHE PATENTANMELDUNG

(11) **EP 2 243 751 A2**
(43) Veröffentlichungstag der Anmeldung: **27.10.2010**
(21) Anmeldenummer: 10004380.1
(22) Anmeldetag: 13.09.2003
(51) Int. Cl.: C03C 17/245, C03C 17/34, C23C 14/00, C23C 14/34, C23C 28/00, C23C 28/04, G02B 1/10, G02B 5/28

(54) **Beschichteter Gegenstand**

(30) Priorität: 14.09.2002 DE 10242848
(62) Teilanmeldung aus: 03757836.6
(71) Anmelder: SCHOTT AG, 55122 Mainz (DE)
(72) Erfinder: Bewig, Lars, Dr., 37581 Bad Gandersheim (DE); Koppe, Frank, 37581 Bad Gandersheim (DE); Küper, Thomas, 37581 Bad Gandersheim (DE); Geisler, Stefan, Dr., 31157 Sarstedt (DE); Bauer, Stefan, Dr., 55232 Alzey (DE)
(74) Vertreter: Blumbach - Zinngrebe

(57) **Zusammenfassung**

Die Erfindung betrifft einen beschichteten Gegenstand, bei dem Beschichtungen trotz Betriebstemperaturen von mehr als 350°C konstant und unverändert qualitativ hochwertig bleibt. Dies gelingt mit Zwischenschichten, die die Morphologie der Beschichtung gezielt unterbrechen und damit stabilisieren.

## Beschreibung

Die Erfindung betrifft einen beschichteten Gegenstand, umfassend ein Substrat und mindestens eine Funktionsschicht mit optischer Funktion und/oder Schutzfunktion, sowie Verfahren zur Herstellung eines derart beschichteten Gegenstandes und dessen Verwendungen.

Beschichtete Gegenstände dieser Art sind seit vielen Jahren bekannt und auch weit verbreitet. Dabei ist es für viele Anwendungen erforderlich, sehr dünne Schichten in Bereichen bis zu wenigen Mikrometern aufzutragen. Diese Beschichtungen können unterschiedlichste Funktionen haben. So gibt es eine Vielzahl von sehr dünnen Schutzschichten, um den Gegenstand beispielsweise vor mechanischen Belastungen zu schützen in Form von "Kratzschutzschichten" etc. Oftmals sollen diese außerdem ein optisch ansprechendes Design aufweisen bzw. völlig transparent sein. Ein weiteres breites Anwendungsgebiet von Beschichtungen sind optische Beschichtungen mit einer Vielzahl von Funktionen und Anwendungen.

Allerdings treten bei vielen Gegenständen der eingangs beschriebenen Art Probleme auf, wenn sie Betriebstemperaturen höher als ca. 350°C ausgesetzt werden. Reflektoren haben zum Beispiel eine Betriebstemperatur von etwa 400 bis 500°C, Kochfelder haben Betriebstemperaturen bis 800°C.

Bei diesen hohen Temperaturen verändern sich amorph aufgetragene Schichten. Die Schichten vollziehen bei steigenden Temperaturen eine Phasenumwandlung, sehr zum Nachteil der Funktionsweise der beschichteten Gegenstände. Die Phasenumwandlung findet beispielsweise bei TiO₂ von der amorphen Phase in die kristalline anatase Phase und weiter von der anatasen Phase in die rutile Phase statt. Mit dieser Phasenumwandlung geht eine Volumenschrumpfung einher, welche sich äußerst negativ auf das Gesamtschichtpaket auswirkt. Bedingt durch die Volumenschrumpfung bilden sich Mikrorisse innerhalb der Schicht. Beispielsweise bei Reflektoren streuen diese dann die einfallende Strahlung, wodurch der maximal erreichbare reflektierte Lichtstrom reduziert wird. Ebenfalls reduziert wird der Reflexionsgrad der Beschichtung. Auch die Oberflächenstruktur der einzelnen Schichten verändert sich dadurch, was bei Wechselschichtsystemen weitere negative Folgen wie z.B. (Teil-) Delaminationen haben kann.

Es ist bekannt, zur Lösung dieses Problems, die Schichten direkt kristallin aufzutragen. Allerdings sind diese Schichten oftmals rauh, nicht trübungsfrei und weisen ein schlechteres Reflexionsverhalten auf.

Eine weitere Möglichkeit das Problem zu umgehen bietet das Dotieren einer Funktionsschicht mit einem SiO₂-Glasbildner. Nachteilig bei diesem Verfahren ist ein niedrigerer Brechungsindex der Funktionsschicht sowie eine komplexere

Prozessführung. Für die gleiche optische Wirkung (Reflexion) benötigt man mehr bzw. dickere Schichtlagen und damit verbunden mehr Aufbauzeit für das Schichtpaket.

Es gibt Studien über Phasenumwandlungen und Kristallisationsverhalten dünner (Wechsel-) Schichten. So ist zum Beispiel aus der Literatur [H. Sankur and W. Gunning, J. Appl. Phys. 66 (1989)] bekannt, dass das Kristallisationsverhalten zum einen von der Temperatur, zum anderen aber auch von der Schichtdicke der einzelnen Schichten abhängt. Kristallisation tritt umso wahrscheinlicher auf, je dicker die jeweiligen Schichten sind und um so mehr sie erwärmt werden.

H. Sankur und W. Gunning fanden heraus, dass Schichten aus TiO₂ bei etwa 350°C von der amorphen Phase in die anatase Phase kristallisieren und bei etwa 600°C und höher in die rutile Phase. Bei ihren Studien hat sich gezeigt, dass bei sehr reinen Schichten unterhalb einer gewissen Schichtdicke, nämlich kleiner ca. 50 nm, die Kristallisation selbst bei höheren Temperaturen dermaßen erschwert ist, dass sie faktisch gar nicht erst eintritt.

Eine weitere Studie zu diesem Thema von D. G. Howitt und A. B. Harker [J. Mater. Res. 2 (2), Mar/Apr 1987] zeigt, dass dünnere Schichten (< 50 nm) nicht kristallisieren, also im amorphen Zustand bleiben, selbst wenn sie für längere Zeit bei höheren Temperaturen erwärmt werden. So zeigte eine Erwärmung über 100 Stunden bei 450°C einer dünnen Schicht (< 50 nm) keine Kristallisation. Dickere Schichten würden bei diesen Bedingungen innerhalb weniger Minuten kristallisieren.

Im Hinblick auf das optische Design ist es in der Regel aber notwendig, Schichten aufzutragen, die eine größere Dicke als 50 nm aufweisen. Das optische Design gibt diesbezüglich einen bestimmten Schichtaufbau vor, d.h. eine genau festgelegte Abfolge der physikalischen Schichtdicken d im Wechselschichtpaket, deren Werte für Anwendungen im sichtbaren Spektralbereich typischerweise bis zu 200 nm betragen können. Die entsprechenden optischen Schichtdicken n·d liegen in der Größenordnung von λ/4 (n: Brechungsindex, λ: Lichtwellenlänge).

Weiterhin hat es sich gezeigt, dass mit den bekannten Verfahren keine ausreichend temperaturbeständige Schichten zu erzeugen sind, die hart, dicht und kratzfest sind, insbesondere dann, wenn diese auch ein dauerhaft optisch ansprechendes Erscheinungsbild haben sollen und/oder transparent sein müssen.

Durch die DE 42 01 914 A1 (= US 5,594,231) ist es beispielsweise bekannt, Abtastfenster aus Glas oder Glaskeramik von in Kassen von Supermärkten und anderen Verbrauchermärkten installierten Abtastsystemen zum Erfassen von auf den Warenverpackungen aufgebrachten Strichkodes, oberseitig mit einer lichtdurchlässigen Hartmaterial-Schicht, auf der wiederum eine lichtdurchlässige gleitfähige Beschichtung aufgebracht ist, zu versehen, um dieses Abtastfenster verschleißfester zu machen. Als Materialien für die Hartstoffschicht werden u.a. Metalloxide wie Al₂O₃ , ZrO₂, SnO₂, Y₂O₃ genannt. Als besonders geeignet wird amorph abgeschiedenes Aluminiumoxid genannt. Gerade die amorphe Abscheidung des Metalloxides begünstigt hier die gewünschten besseren Härte- und Gleiteigenschaften der Schutzschicht. Die hier beschriebenen Hartstoffschichten sind für Anwendungen im Raumtemperaturbereich geeignet, verändern jedoch ihre Eigenschaften bei hohen Temperaturen, wie sie beispielsweise bei Kochflächen üblich sind, was sie für. Verwendung bei hohen Temperaturen ungeeignet macht. Eine Schutzschicht für Kochflächen erfordert Materialien, die bis zu 800° C temperaturbeständig sind und die die hohen, zwischen der Glaskeramik und Schutzschicht auftretenden thermo-mechanischen Spannungen auszuhalten vermögen.

Durch die DE 201 06 167 U1 ist ein Kochfeld mit einer Glaskeramikplatte als Kochfläche bekannt geworden, die mit einer transparenten Kratzschutzschicht versehen ist, die u.a. durch eine Hartstoffschicht gebildet werden kann. Als Materialien für diese transparente Schicht werden u.a. Metalloxide wie Aluminiumoxid, Zirkonoxid, Yttriumoxid, Zinnoxid, Indiumoxid und Kombinationen daraus genannt. Das Abscheiden der Materialien kann nach dieser Schrift z.B. durch die SOL GEL-Technik, die CVD-Verfahren, insbesondere durch das PICVD Verfahren und durch Sputtern erfolgen.

Mit den bekannten Verfahren zur Herstellung von Hartstoffschichten wie sie beispielsweise in den o.g. Schriften DE 42 01 914 A1 und DE 201 06 167 U1 beschrieben sind, werden die Schichten typischerweise amorph oder in teilkristalliner Struktur abgeschieden. Derartige Schichten können bei längerem Gebrauch in den Heißbereichen bzw. im Fall maximaler thermischer Belastung nachteilige Veränderungen erfahren. So können sich in diesen Bereichen die Schichten durch thermisch induzierte Kompaktierung verfärben bzw. durch Kristallisation eintrüben, mit der Folge, daß die Heißbereiche optisch auffällig werden. Ferner kann es zu einer Aufrauhung im Maßstab 1 - 1000 nm kommen. Die Aufrauhung selbst kann bereits eine optische Auffälligkeit bewirken, wobei die entstehenden Vertiefungen zusätzlich zu einer erschwerten Reinigung führen. Die Kristallisationsproblematik in den Heißbereichen verschärft ein mechanisches Versagen der Kratzschutzschicht. Bei der Kristallisation ändert sich der Aufbau der Schicht, so dass Risse in der Schicht entstehen. Durch den Verlust des lateralen Zusammenhalts bietet die Schicht keinen besonderen Kratzschutz mehr.

Aus dem Anwendungsbereich der Turbinentechnik ist es bekannt, dass säulenförmig gewachsene Schichten eine besonders hohe Widerstandsfähigkeit gegenüber schnellen thermischen Wechsellasten besitzen. So beschreibt die US 4 321 311 die Verwendung einer kolumnar gewachsenen keramischen Schicht als thermischen Schutz für metallische Komponenten des Turbinenbaus. Die hierin beschriebenen Schichten haben jedoch aufgrund ihrer groben kristallinen Strukturen eine große Rauhigkeit bzw. Porosität.

Rauhe und poröse Oberflächen verschmutzen schnell und sind schwer zu reinigen. Sie sind außerdem optisch nicht klar transparent, sondern stark streuend und für Anwendungen mit optisch ansprechenden Oberflächen nicht geeignet.

Der Erfindung liegt somit die Aufgabe zugrunde, beschichtete Gegenstände der eingangs genannten Art, möglichst kostengünstig sowie qualitativ hochwertig bereitzustellen, wobei die Beschichtung auch bei Betriebstemperaturen oberhalb von 350°C strukturstabil ist und deren optische und/oder mechanische Eigenschaften weiter verbessert werden.

Die vorstehende Aufgabe wird durch den in den Ansprüchen 1 bis 66 beschriebenen Gegenstand gelöst.

Erfindungsgemäß weist mindestens eine Funktionsschicht des beschichteten Gegenstandes mindestens eine Zwischenschicht auf, wobei die Zwischenschicht eine im Verhältnis zur Funktionsschicht sehr dünne Schicht ist mit einer Schichtdicke d_{z} ≤ 10 nm und die Zwischenschicht die Morphologie der Funktionsschicht unterbricht, so dass die Nachteile des Standes der Technik nicht mehr auftreten.

Als Funktionsschichten werden solche Schichten bezeichnet, die eine optische Funktion erfüllen (d.h diese Schichten haben durch die Wahl des Brechungsindex und der Schichtdicke eine Funktion hinsichtlich ihrer Wirkung auf die Strahlung innerhalb eines bestimmten Bereiches des elektromagnetischen Spektrums) und/oder eine Schutzfunktion hinsichtlich des Substrates, beispielsweise vor thermischen, chemischen oder mechanischen Einwirkungen haben.

Ist die Funktionsschicht eine überwiegend amorphe Schicht oder eine Schicht in einer instabilen Kristallphase, kann die Zwischenschicht die Morphologie einer solchen Funktionsschicht derart mindestens einmal unterbrechen, dass die entstehenden Teilschichten Tₛ der Funktionsschicht unter einer vorgegebenen Schichtdicke bleiben, bei welcher eine Phasenumwandlung, beispielsweise von der amorphen in die anastase kristalline Phase oder von der anastasen in die rutile kristalline Phase, der Funktionsschicht nicht mehr auftritt.

Es hat sich überraschend gezeigt, dass die dünnen Zwischenschichten die Morphologie beispielsweise an sich bekannter Funktionsschichten hinsichtlich ihrer Temperaturbeständigkeit positiv verändern, ohne deren ursprünglichen Funktionen negativ zu beeinflussen. Dadurch gelingt es, beispielsweise amorphe Funktionsschichten oder Funktionsschichten in temperaturinstabilen Kristallphasen mit vorteilhaften mechanischen und optischen Eigenschaften außerdem struktur- und temperaturstabil zu gestalten und auch in Hochtemperaturbereichen einzusetzen.

Ist die Funktionsschicht eine überwiegend kristalline Schicht, vorzugsweise in einer temperaturstabilen Kristallphase, kann die Zwischenschicht die Morphologie einer solchen Funktionsschicht mindestens einmal unterbrechen, so dass Teilschichten Tₛ entstehen. Die Unterbrechung bewirkt, dass sich in der Funktionsschicht lateral eng zusammenhängende, senkrecht zur Substratoberfläche aufwachsende dichte Säulen ausbilden, die im wesentlichen keine Tendenz zur Verbreiterung zeigen.

Die Zwischenschichten beeinflussen die Morphologie der kristallinen Schichten hauptsächlich derart, dass mittels der Zwischenschichten Kristallorientierungen unterdrückt werden, die eine Tendenz zur Verbreiterung beim Wachstum der Schicht aufweisen, so dass die Funktionsschichten sehr dicht sind und sehr glatte Oberflächen aufweisen. Dadurch gelingt es, kristallinen Schichten mit hoher Temperaturbeständigkeit optisch hochwertige Eigenschaften zu verleihen und sehr dichte, kratzfeste und temperaturbeständige Schichten bereitzustellen.

Weiterhin ist auch eine kombinierte Wirkung der oben beschriebenen Einflüsse der Zwischenschichten auf Funktionsschichten möglich.

Die Funktionsschicht kann ein Oxid, Nitrid, Carbid, Fluorid, Chlorid, Selenid, Tellurid oder Sulfid enthalten und/oder verbunden sein mit einem oder mehreren der folgenden Elemente Li (Lithium), Be (Beryllium), Na (Natrium), Mg (Magnesium), Al (Aluminium), Si (Silizium), Ca (Calcium), Sc (Scandium), Ti (Titan), Cr (Chrom), Zn (Zink), Ge (Germanium), Sr (Strontium), Y (Yttrium), Nb (Niob), Cd (Cadmium), In (Indium), Sn (Zinn), Sb (Antimon), Te (Tellur), La (Lanthan), Ce (Cer), Pr (Praseodym), Nd (Neodym), Sm (Samarium), Gd (Gadolinium), Yb (Ytterbium), Lu (Lutetium), Hf (Hafnium), Zr (Zirkon), Ta (Tantal), Tl (Thallium), Pb (Blei), Bi (Bismut), und/oder Th (Thorium).

Weiterhin kann die Funktionsschicht aber auch aus einem reinem Material der o.g. genannten Elemente oder aus Mischsystemen aus Oxid- und/oder Nitrid- und/oder Carbid-und/oder Fluorid- und/oder Chlorid- und/oder Selenid-und/oder Tellurid- und/oder Sulfid-Verbindungen der Elemente bestehen, beispielsweise aus Mischsystemen mit mindestens einem Metalloxid und/oder Metallnitrid und/oder Metallcarbid und/oder Metalloxonitrid und/oder Metallcarbonitrid und/oder Metalloxocarbonitrid. Ebenso können die vorgenannten Mischsysteme mehrere metallische Komponenten enthalten, beispielsweise aus Titan-Aluminium-Oxid bestehen.

Die Beschichtungen können sowohl aus nur einer Funktionsschicht als auch aus mehreren verschiedenen Funktionsschichten bestehen. Die Wahl der Materialien und Materialkombinationen, der Aufbau und die Zusammensetzung der einzelnen Funktionsschichten wird im wesentlichen durch die Anforderung an die Schicht bestimmt.

Die Zwischenschichten können ebenfalls die für die Funktionsschichten o.g. Elemente, Verbindungen und Mischsysteme enthalten.

Eine wirksame Unterbrechung der Morphologie der Funktionsschichten durch die dünnen Zwischenschichten ist vorteilhafterweise dann zu erreichen, wenn die Zwischenschicht eine andere chemische Zusammensetzung und/oder eine andere Morphologie als die zu unterbrechende Funktionsschicht aufweist.

Für optische Funktionsschichten liegen die Schichtdicken im Bereich von 10 bis 1000 nm, bevorzugt im Bereich zwischen 30 bis 500 nm. Optische Funktionsschichten sind optisch wirksame Schichten, d.h. diese haben eine Funktion hinsichtlich ihrer Wirkung auf die Strahlung innerhalb eines bestimmten Bereiches des elektromagnetischen Spektrums.

Es hat sich überraschend gezeigt, dass sehr dünne Zwischenschichten (= 10 nm) in den meisten Fällen nicht relevant für das optische Design bzw. das spektrale Reflexionsverhalten des Schichtaufbaus sind. Sehr wohl aber verhindern diese unerwünschte morphologische Strukturen einer optischen Funktionsschicht. Somit kann eine optische Funktionsschicht durch sehr dünne Zwischenschichten ohne Beeinflussung des Reflexionsverhaltens geteilt werden und ist auch bei höheren Temperaturen strukturstabil.

Die Dicke einer Teilschicht kann von einem Fachmann anhand weniger Versuche leicht eingestellt werden. Sie richtet sich zum einen nach dem Material der optischen Funktionsschicht, zum anderen nach der zu erwartenden Temperaturbelastung der Schicht während des Einsatzes. Die sich bei der Teilung einer optischen Funktionsschicht ergebenden Schichtdicken der Teilschichten Tₛ sollten 10 bis 70 nm, vorzugsweise 20 bis 45 nm betragen. Falls eine einmalige Unterbrechung der Funktionsschicht keine befriedigende Wirkung wegen zu hoher Schichtdicke der Teilschichten oder aus einem sonstigen Grund ergibt, werden mehrere Zwischenschichten benutzt. Die entstehenden Teilschichten müssen nicht dieselbe Schichtdicke besitzen, sondern können unterschiedliche Schichtdicken haben, d.h. asymmetrisch aufgebaut sein. Die Funktion einer einzelnen optischen Funktionsschicht wird weitgehend nur durch die Gesamtdicke ihrer Teilschichten bestimmt. Sobald die Teilschichten die für den gewünschten Anwendungszweck erforderliche (geringe) Dicke besitzen, führt eine weitere Verringerung der Schichtdicke der Teilschichten durch Zwischenschalten weiterer Zwischenschichten zu keiner wesentlichen Verbesserung mehr. Schichtdicken von Teilschichten im Bereich von 45 bis 70 nm sollten nur Verwendung für Gegenstände finden, die einer thermischen Belastung um 350°C ausgesetzt sind. Im Schichtdickenbereich von 20 bis 45 nm tritt auch bei sehr hohen Temperaturen über 350°C keine Verschlechterung der Eigenschaften auf.

Die Schichtdicke der Zwischenschicht für optische Funktionsschichten sollte von 0,3 bis 10 nm, vorzugsweise von 1 bis 3 nm, besonders bevorzugt von 1,5 bis 2,5 nm reichen. Mit diesen Parametern ist sichergestellt, dass die Zwischenschicht nur die Morphologie der Schicht beeinflusst, nicht aber das optische Design. Unterhalb 0,3 nm hat die Zwischenschicht kaum noch eine Wirkung, oberhalb 10 nm kann die Zwischenschicht unerwünscht optisch aktiv werden.

Das Prinzip der Unterbrechung der Funktionsschichten durch Zwischenschichten kann bei beliebigen Materialkombinationen der Funktionsschichten angewendet werden. Dabei können beispielsweise in optischen Wechselschichtsystemen niedrigbrechende Funktionsschichten mit Zwischenschichten aus dem hochbrechenden Material zerlegt und hochbrechende Funktionsschichten mit Zwischenschichten aus dem niedrigbrechenden Material zerlegt werden. Diese Vorgehensweise ist jedoch nicht zwangsläufig notwendig, lediglich unter vefahrenstechnischen Aspekten sinnvoll. Es ist also ebenso möglich, dass die hochbrechende Funktionsschicht durch eine andere hochbrechende Zwischenschicht unterbrochen wird, beispielsweise eine Titan-Oxid-Funktionsschicht durch eine Titan-Aluminium-Oxid-Zwischenschicht.

Als Material für optische Funktionsschichten eignen sich hauptsächlich Metalloxide, für die hochbrechenden Funktionsschichten insbesondere Titanoxid, Titan-Aluminium-Oxid sowie Zirkonoxid in einer temperaturstabilen Kristallphase und für die niedrigbrechenden Funktionsschichten insbesondere Siliziumoxid.

Ein weiterer vorteilhafter Aspekt der Erfindung ist es, dass beispielsweise bei kristallin aufgetragenen optischen Funktionsschichten durch deren Unterbrechung mit Zwischenschichten deren Oberflächenqualität wesentlich verbessert werden kann. Neben einer erhöhten Temperaturbeständigkeit erzielt man Oberflächen mit erhöhter Brillianz und verbesserten optischen Eigenschaften sowie einer erhöhten Widerstandsfähigkeit gegenüber mechanischen Belastungen.

Weitere Funktionsschichten aus Metall, beispielsweise für Oberflächenbeschichtungen von Bauelementen, insbesondere Trägerelementen litographischer Prozesse, können vorteilhafterweise durch Zwischenschichten aus Metalloxiden, insbesondere aus Metalloxiden des gleichen Metalles unterbrochen werden. So erreicht man beispielsweise durch Unterbrechung von Chrom-Funktionsschichten mit Chrom-Oxid-Zwischenschichten eine wesentliche Qualitätsverbesserung derartiger Beschichtungen durch wesentlich glattere Oberflächen.

Der zu beschichtende Gegenstand kann entweder ein Metall, oder ein dielektrisches Substrat, also ein Glas, eine Glaskeramik oder ein Komposit sein. Es kann aber auch ein Kunststoff als Substrat eingesetzt werden, welcher unter den Einsatztemperaturen stabil ist, wie beispielsweise COC (Cyclo-Olefin-Copolymere), PES (Polyethersulfon), PEI (Polyetherimid), COP (Cyclo-Olefin-Polymere) oder Derivate, Mischungen, Copolymere und Blends der vorangehenden Stoffe.

Jedoch können auch alle anderen Kunststoffe als Substrat für den erfindungsgemäßen beschichteten Gegenstand dienen.

Die Erfindung betrifft ferner die Verwendung eines derart beschichteten Gegenstandes, wobei die Gegenstände insbesondere für eine Anwendung unter hoher thermischer Belastung geeignet sind. Beschichtete Gegenstände dieser Art werden typischerweise für optische Elemente verwendet. Diese können Reflektoren, Linsen, Filter, Prismen und Spiegel sein. Auch sind Leuchtkörper für die digitale Projektion, Bühnenbeleuchtung oder Architekturbeleuchtung denkbar. Die optischen Elemente können erfindungsgemäß auch für den UV-Wellenlängenbereich wie für den IR-Wellenlängenbereich eingesetzt werden. Auch die Verwendungen als Display für Monitore und Anzeigegeräte ist bei entsprechender Wahl des Substrates und der Schichtmaterialien möglich.

Sind die Funktionsschichten Schutzschichten, beispielsweise Hartstoff-Schutzschichten als sogenannte "Kratzschutzschichten", liegen deren Schichtdicken typischerweise im Bereich von 100 bis 20000 nm, bevorzugt zwischen 500 bis 10000 nm und besonders bevorzugt zwischen 1500 bis 5000 nm.

Die Dicke einer Teilschicht kann hier ebenfalls von einem Fachmann anhand weniger Versuche leicht eingestellt werden. Sie richtet sich vor allem nach dem Material der Schutzschicht. Die sich bei der Teilung einer solchen Funktionsschicht durch die Zwischenschicht ergebenden Schichtdicken der Teilschichten sollten 30 bis 500 nm, vorzugsweise 100 bis 250 nm betragen. Falls eine einmalige Unterbrechung der Funktionsschicht keine befriedigende Wirkung wegen zu hoher Schichtdicke der Teilschichten oder aus einem sonstigen Grund ergibt, werden mehrere Zwischenschichten benutzt. Die entstehenden Teilschichten müssen nicht dieselbe Schichtdicke besitzen, sondern können unterschiedliche Schichtdicken haben, d.h. asymmetrisch aufgebaut sein.

Die Zwischenschichten in den Schutzschichten müssen im Verhältnis zur Funktionsschicht sehr dünne Schichten sein und liegen im Bereich von 0,3 bis 10 nm, vorzugsweise im Bereich von 1 bis 5nm.

Bei kristallinen Schutzschichten läßt sich beispielsweise mit der Unterbrechung der aufwachsenden kolumnaren Srukturen durch Zwischenschichten die laterale Ausdehnung der Kolumnen auf Bereiche unter 1 µm, vorzugsweise bis unter 200 nm beschränken, wodurch die Schichten sehr dicht werden.

Geeignete Materialien derartiger Funktionsschichten als Schutzschichten, insbesondere für transparente Schutzschichten sind Siliziumnitrid und Metalloxide, insbesondere Zirkonoxid in einer temperaturstabilen Kristallphase, beispielsweise mit Yttrium stabilisiertes Zirkonoxid. Für unterbrechende Zwischenschichten finden beispielsweise Zirkonnitrid, Siliziumoxid oder Titan-Aluminium-Oxid Verwendung.

Der zu beschichtende Gegenstand kann entweder ein Glas, eine Glaskeramik oder ein Komposit sein. Jedoch können auch andere geeignete Materialien als Substrat für den erfindungsgemäßen beschichteten Gegenstand dienen.

Die Erfindung betrifft ferner die Verwendung eines derart beschichteten Gegenstandes, wobei die Gegenstände insbesondere für eine Anwendung unter hoher thermischer Belastung geeignet sind. Beschichtete Gegenstände dieser Art werden typischerweise als Kochflächen für Kochfelder verwendet.

Ein weiterer erfindungsgemäßer beschichteter Gegenstand, umfassend ein Substrat mit mindestens einer Funktionsschicht, ist so ausgebildet, dass mindestens eine Funktionsschicht mindestens eine von der Funktionsschicht verschiedenen Zwischenschicht aufweist, wobei die Zwischenschicht die gleiche Brechzahl aufweist wie die Funktionsschicht und die Zwischenschicht die Morphologie der Funktionsschicht unterbricht.

Die hier notwendige Unterbrechung der Funktionsschicht mit einer Zwischenschicht hat prinzipiell die gleiche Wirkung auf die Morphologie der Funktionsschicht wie zuvor beschrieben, muss jedoch nicht mehr die geringe Dicke von weniger als 10 nm aufweisen. Da die Zwischenschicht den gleichen Brechungsindex aufweist wie die Funktionsschicht, kann sie deren optische Funktion nicht verändern. Dies ist vor allem für transparente Funktionsschichten mit Schutzfunktionen und für optische Funktionsschichten von Bedeutung.

Transparente Funktionsschichten mit Schutzfunktionen und/oder optische Funktionsschichten bestehen vorrangig aus Metalloxiden. Die Unterbrechung mit einer Zwischenschicht, die den gleichen Brechungsindex aufweist, gelingt dabei vorzugsweise durch Zwischenschichten aus geeigneten Metalloxiden mit mindestens zwei metallischen Komponenten, wobei das Mengenverhältnis der Komponenten abstimmbar und ein bestimmter Brechungsindex einstellbar ist.

Analog dazu erfolgt eine Unterbrechung von Funktionsschichten aus Metalloxiden mit mindestens zwei metallischen Komponenten mit Zwischenschichten aus einem Metalloxid.

Eine mögliche und geeignete Ausführung ist beispielsweise die Unterbrechung von Zirkonoxid-Funktionsschichten mit Titan-Aluminium-Oxid-Zwischenschichten und umgekehrt.

Der Brechungsindex von Zirkonoxid liegt bei ca. 2,1 und der Brechungsindex von Titan-Aluminim-Oxid ist in einem Bereich von ca. 1,55 bis 2,50 über die Einstellung von Aluminium zu Titan variierbar. Durch ein gezieltes Mengenverhältnis der beiden metallischen Komponenten kann die Brechzahl der Titan-Aluminium-Oxid-Schicht der Brechzahl der Zirkonoxid-Schicht angepasst werden.

Diese Vorgehensweise ist analog auch für weitere Metalloxide anwendbar.

Als Verfahren zur Herstellung der beschriebenen beschichteten Gegenstände kommt das Chemical Vapour

Deposition (CVD), oder das Physical Vapour Deposition (PVD) Verfahren in Frage.

Die drei Haupttechniken des CVD sind das Thermische CVD, das Plasma CVD und das Laser CVD. Sie unterscheiden sich in der Art der Anregung und Aufspaltung der chemischen Vorverbindungen (Precursor), die als verdampfbares Transportmittel für Komponenten der Schichtmaterialien fungieren.

Vorteilhaft ist eine der Varianten des Plasma CVD zur Herstellung des eingangs beschriebenen Gegenstandes, insbesondere bei der Herstellung amorpher Funktionsschichten, nämlich das **P**lasma-**A**ssisted-Chemical-**V**apour-**D**eposition (PACVD), das **P**lasma-**E**nhanced-Chemical-**V**apour-**D**eposition (PECVD), und besonders vorteilhaft das **P**lasma-**I**mpulse-**C**hemical-**V**apour-**D**eposition (PICVD). Bei zuletzt genanntem Verfahren findet die Schichtabscheidung diskontinuierlich in einem durch gepulste Mikrowellenstrahlung angeregten Plasma statt. Ein gezielter Schichtaufbau der jeweiligen Funktionsschichten und der Zwischenschicht wird über die Anzahl der Pulszyklen gesteuert. Die geringste Schichtdicke, die bei genau einem Pulszyklus abgeschieden wird, kann auf 0,1 bis 0,3 nm pro Puls eingestellt werden.

Bei PICVD ist der Herstellungsaufwand abhängig von der Gesamtpaketdicke und nicht von der Anzahl der verschiedenen Schichten. Die Umschaltzeit bei PICVD von Schicht zu Schicht beträgt ca. 10 Millisekunden. Dies ist ein wirtschaftlich besonders vorteilhaftes Verfahren, da bei anderen Herstellungsverfahren der Produktionsaufwand mit der Anzahl der verschiedenen Schichten steigt, der Kostenpunkt der Herstellung also die Anzahl der Schichten ist.

Zur Erzeugung kristalliner Schichtmorphologien eignen sich besonders physikalische Aufdampfprozesse mit hohen Energieeinträgen wie beispielsweise Sputterverfahren.

Jedoch sind nicht alle Sputterverfahren hinsichtlich ihrer Wirtschaftlichkeit für industrielle Beschichtungen geeignet. Unter diesem Aspekt eignen sich insbesondere Magnetronverfahren für die Herstellung erfindungsgemäßer Gegenstände. Magnetron-Sputtersysteme ermöglichen hohe Beschichtungsraten im niedrigen Druckbereich bei relativ geringer Substraterwärmung und sind in den Prozeßparametern ebenfalls gut steuerbar.

Insbesondere zur Herstellung von Schichten aus Mischsystemen eignen sich Sputterverfahren, bei denen ein gleichzeitiges Sputtern mit zwei Sputterquellen (Co-Sputtern), die mit verschiedenen Targetmaterialien bestückt sind erfolgen kann.

Im weiteren folgen Ausführungsbeispiele für einen erfindungsgemäßen beschichteten Gegenstand, wobei dieser nicht auf diese Ausführungen beschränkt ist.

Es zeigt dazu
Figur 1: den Querschnitt durch ein beschichtetes Substrat mit symmetrischer Teilung von Funktionsschichten,
Figur 2: den Querschnitt durch ein beschichtetes Substrat mit asymmetrischer Teilung von Funktionsschichten,
Figur 3: Reflexionsverhalten eines beispielhaften Reflektors mit und ohne Zwischenschichten

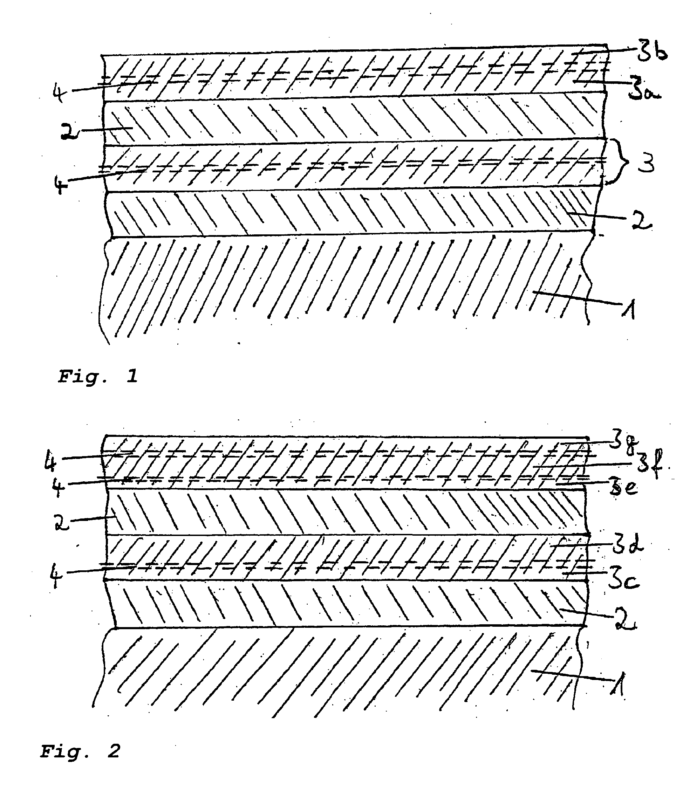

Figur 1 zeigt den Querschnitt einer besonders bevorzugten Ausführungsform des erfindungsgemäßen beschichteten Substrates (1). Die direkt auf das Substrat aufgebrachte Schicht (2) stellt eine Funktionsschicht B dar, die in ihren Ausmaßen keine erfinderischen Elemente enthält. Darauf folgend nun die Funktionsschicht A (3), die durch die Zwischenschicht (4) in die Teilschichten Tₛ (3a und 3b) geteilt ist.

Wie anhand der Figur 1 zu sehen ist, kann auf die geteilte Funktionsschicht A eine weitere Funktionsschicht B aufgetragen sein. Diese Aufeinanderschichtung soll so oft erfolgen, bis die gewünschte Wirkung der Beschichtung erreicht ist.

Figur 2 zeigt eine weitere Ausführungsform, bei der die Funktionsschicht A (3) in Teilschichten Tₛ (3c und 3d) asymmetrisch geteilt sind. Ferner zeigt die Figur 2 die Möglichkeit, die Funktionsschicht A mehrmals zu teilen, in diesem Beispiel in die Teilschichten Tₛ (3e, 3f, 3g).

Nachfolgend je ein exemplarisches Beispiel für die Beschichtung mit (Tabelle 2) und vergleichend ohne (Tabelle 1) die Zwischenschichten anhand eines Kaltlicht-Schichtdesigns auf einem Reflektor.

Die in den Tabellen beschriebene Schicht 1. ist dem Substrat am nächsten.

**Tabelle 1: 25 Schichten auf dem Substrat ohne Zwischenschichten.**

| # Schicht | Material | Dicke [nm] | Schichtart |
|---|---|---|---|
| 1. | SiO₂ | 26.91 | Funktionsschicht B |
| 2. | TiO₂ | 102.96 | Funktionsschicht A |
| 3. | SiO₂ | 62.79 | Funktionsschicht B |
| 4. | TiO₂ | 80.00 | Funktionsschicht A |
| 5. | SiO₂ | 127.71 | Funktionsschicht B |
| 6. | TiO₂ | 64.62 | Funktionsschicht A |
| 7. | SiO₂ | 118.09 | Funktionsschicht B |
| 8. | TiO₂ | 68.30 | Funktionsschicht A |
| 9. | SiO₂ | 120.00 | Funktionsschicht B |
| 10. | TiO₂ | 63.40 | Funktionsschicht A |
| 11. | SiO₂ | 108.32 | Funktionsschicht B |
| 12. | TiO₂ | 60.44 | Funktionsschicht A |
| 13. | SiO₂ | 165.62 | Funktionsschicht B |
| 14. | TiO₂ | 32.39 | Funktionsschicht A |
| 15. | SiO₂ | 85.95 | Funktionsschicht B |
| 16. | TiO₂ | 40.00 | Funktionsschicht A |
| 17. | SiO₂ | 93.54 | Funktionsschicht B |
| 18. | TiO₂ | 53.32 | Funktionsschicht A |
| 19. | SiO₂ | 99.06 | Funktionsschicht B |
| 20. | TiO₂ | 52.66 | Funktionsschicht A |
| 21. | SiO₂ | 80.48 | Funktionsschicht B |
| 22. | TiO₂ | 46.28 | Funktionsschicht A |
| 23. | SiO₂ | 82.98 | Funktionsschicht B |
| 24. | TiO₂ | 31.65 | Funktionsschicht A |
| 25. | SiO₂ | 18.42 | Funktionsschicht B |

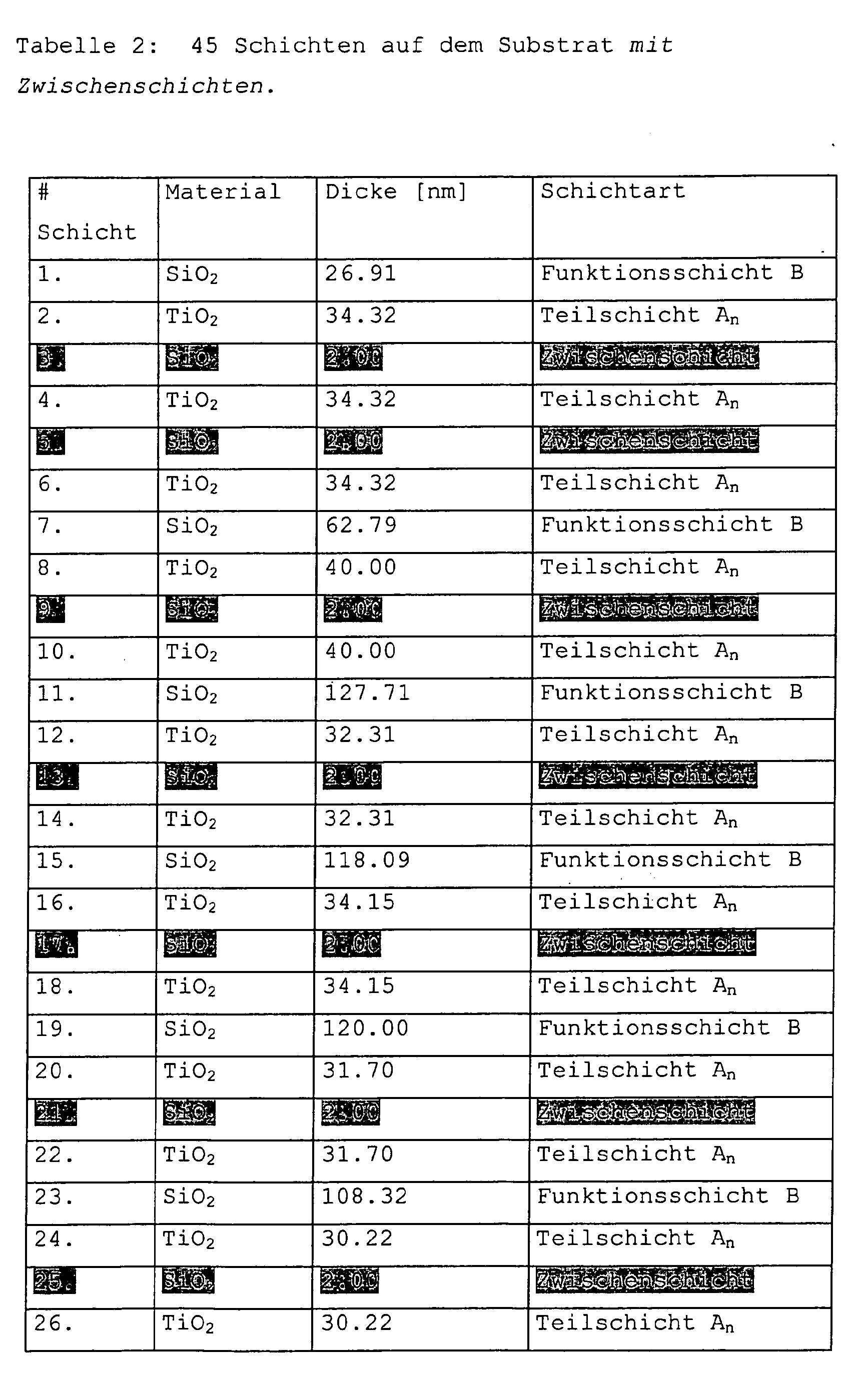

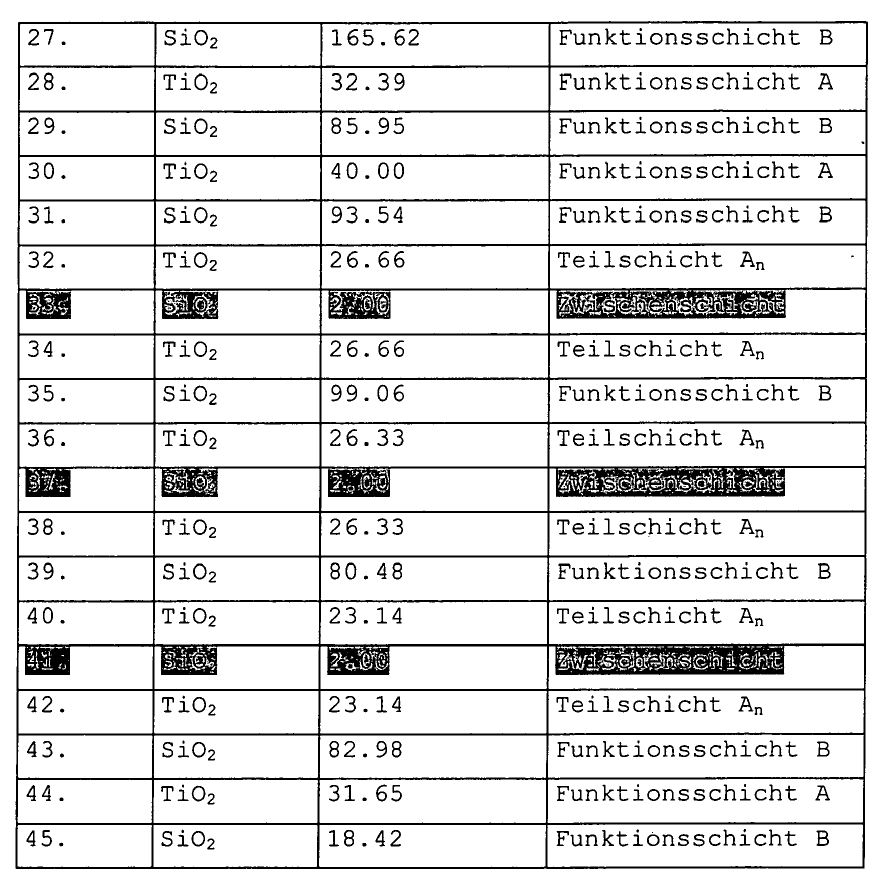

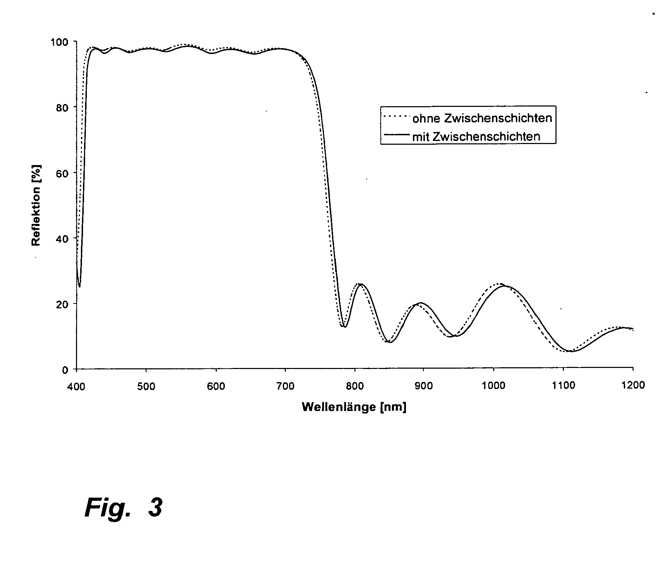

Die in Figur 3 gezeigte Grafik zeigt das spektrale Verhalten des Reflektors ohne Zwischenschichten (Tabelle 1) als gestrichelte Linie und das spektrale Verhalten des Reflektors mit Zwischenschichten (Tabelle 2) als durchgezogene Linie. Wie zu erkennen ist, bewirken die Zwischenschichten nur eine minimale Änderung des Spektrums, die zudem durch eine leichte Variation der Schichtdicken weitgehend kompensiert werden kann. Jedoch ist ein Reflektor mit Zwischenschichten bei wesentlich höheren Betriebstemperaturen einsetzbar bei gleichbleibender optischer Qualität.

## Patentansprüche

1. Beschichteter Leuchtkörper, umfassend ein Substrat mit einem optischen Wechselschichtsystem aus hochbrechenden Funktionsschichten und niedrigbrechenden Funktionsschichten, und wobei zumindest eine Funktionsschicht mindestens ein Oxid und zumindest eines der Elemente Ti oder Ta enthält, und wobei in der Funktionsschicht mindestens eine Zwischenschicht angeordnet ist, wobei diese Zwischenschicht eine Schichtdicke von d_{z} ≤ 10 nm aufweist, und diese Zwischenschicht die Morphologie der Funktionsschicht unterbricht, wobei die Zwischenschicht eine andere chemische Zusammensetzung und vorzugsweise eine andere Morphologie als die Funktionsschicht aufweist, und wobei das Substrat ein dielektrisches Substrat ist.

2. Beschichteter Leuchtkörper nach Anspruch 1, ***dadurch gekennzeichnet,* dass** die Funktionsschicht mittels einer Zwischenschicht mit einer Schichtdicke d_{z} ≤ 10 nm derart mindestens einmal unterbrochen wird, dass die entstehenden Teilschichten Tₛ der Funktionsschicht unter einer vorgegebenen Schichtdicke bleiben, bei welcher eine Phasenumwandlung der Funktionsschicht nicht mehr auftritt.

3. Beschichteter Leuchtkörper nach einem der vorhergehenden Ansprüche, ***dadurch gekennzeichnet,* dass** die Zwischenschicht die Elemente Si, Zr, Sn oder Ta enthält.

4. Beschichteter Gegenstand nach einem der vorstehenden Ansprüche, ***dadurch gekennzeichnet,* dass** die Schichtdicke der Teilschichten Tₛ 10 bis 70 nm, vorzugsweise 20 bis 45 nm beträgt.

5. Beschichteter Leuchtkörper nach Anspruch 4, ***dadurch gekennzeichnet,* dass** die Schichtdicke d_{z} der Zwischenschicht 0,3 bis 10 nm, vorzugsweise 1 bis 3 nm, besonders bevorzugt 1,5 bis 2,5 nm beträgt.

6. Beschichteter Leuchtkörper nach einem der vorstehenden Ansprüche, ***dadurch gekennzeichnet,* dass** hochbrechende Funktionsschichten von niedrigbrechenden Zwischenschichten unterbrochen sind und/oder dass niedrigbrechende Funktionsschichten von hochbrechenden Zwischenschichten unterbrochen sind.

7. Beschichteter Leuchtkörper nach einem der vorstehenden Ansprüche, ***dadurch gekennzeichnet,* dass** die hochbrechende Funktionsschicht und/oder die hochbrechende Zwischenschicht Titanoxid umfasst.

8. Beschichteter Leuchtkörper nach einem der Ansprüche 5 bis 7, ***dadurch gekennzeichnet,* dass** die niedrigbrechende Funktionsschicht und/oder die niedrigbrechende Zwischenschicht Siliziumoxid umfasst.

9. Beschichteter Leuchtkörper nach einem der vorstehenden Ansprüche, ***dadurch gekennzeichnet,* dass** das dielektrische Substrat ein Glas ist.

10. Beschichteter Leuchtkörper nach einem der Ansprüche 6 bis 9, ***gekennzeichnet durch*** seine Verwendung als Leuchtkörper für die digitale Projektion, für die Bühnen- oder Architekturbeleuchtung oder den UV- oder IR-Wellenlängenbereich.

11. Verfahren zur Herstellung eines beschichteten Leuchtkörpers gemäß einem der Ansprüche 1 bis 10, ***dadurch gekennzeichnet,* dass** die Beschichtung mit einem CVD oder PVD Verfahren aufgebracht wird.

12. Verfahren zur Herstellung eines beschichteten Leuchtkörpers nach Anspruch 11, ***dadurch gekennzeichnet,* dass** die Beschichtung mit einem reaktiven CVD Verfahren aufgebracht wird, vorzugsweise ausgewählt aus der Gruppe:
- PICVD (**P**lasma-**I**mpulse-**C**hemical-**V**apour-**D**eposition)
- PECVD (**P**lasma-**E**nhanced-**C**hemical-**V**apour-**D**eposition)
- PACVD (**P**lasma-**A**ssisted-**C**hemical-**V**apour-**D**eposition)
- TCVD (**T**hermal-**C**hemical-**V**apour-**D**eposition)

13. Verfahren zur Herstellung eines beschichteten Leuchtkörpers nach Anspruch 12, ***dadurch gekennzeichnet,* dass** die Beschichtung diskontinuierlich in Form von Pulszyklen aufgebracht wird, wobei über die Anzahl der Zyklen die Dicke einer jeweiligen Funktionsschicht und
Zwischenschicht eingestellt wird.

14. Verfahren zur Herstellung eines beschichteten Leuchtkörpers nach Anspruch 13, ***dadurch gekennzeichnet,* dass** die jeweils geringste Schichtdicke, die bei genau einem Pulszyklus aufgebracht wird, auf 0,1 bis 0,3 nm eingestellt werden kann.

15. Verfahren zur Herstellung eines beschichteten Leuchtkörpers nach Anspruch 11, ***dadurch gekennzeichnet,* dass** die Beschichtung mit einem reaktiven PVD Verfahren aufgebracht wird, vorzugsweise mit Magnetronsputtern oder dass die Beschichtung mit einem reaktiven ionenstrahlunterstützten PVD Verfahren aufgebracht wird, vorzugsweise mit ionenstrahlunterstütztem Elektronenstrahlverdampfen.
